# EUROPÄISCHE PATENTANMELDUNG

(11) **EP 2 802 014 A1**
(43) Veröffentlichungstag der Anmeldung: **12.11.2014**
(21) Anmeldenummer: 14002050.4
(22) Anmeldetag: 16.03.2012
(51) Int. Cl.: H01L 31/00, H01L 31/02, H02H 3/20, H02J 3/16, H02J 3/18, H02J 3/26, H02J 3/38

(54) **Wechselrichter**

(30) Priorität: 19.03.2011 DE 102011014468; 19.03.2011 DE 102011014469; 29.03.2011 DE 102011015392
(62) Teilanmeldung aus: 12735085.8
(71) Anmelder: Adensis GmbH, 01129 Dresden (DE)
(72) Erfinder: Beck, Bernhard, 97332 Volkach OT Dimbach (DE)
(74) Vertreter: FDST Patentanwälte

(57) **Zusammenfassung**

Ein Wechselrichter (9), insbesondere einer Photovoltaikanlage, der an ein DreiPhasen-Drehstromversorgungsnetz zur Einspeisung regenerativ erzeugter Energie anschließbar ist, weist Mittel (103, E), insbesondere eine Regel- und/oder Steuereinheit oder einen Steuereingang, zur Veränderung des Betriebsmodus bei Anliegen eines Steuersignals derart auf, dass seitens des Wechselrichters eine bezüglich der drei Phasen (L1, L2, L3) unsymmetrische Einspeisung von Blindleistung in das oder ein unsymmetrischer Bezug von Blindleistung aus dem Versorgungsnetz (201) erfolgt, oder dass der Wechselrichter (9) auf einer Phase (L1, L2, L3) Leistung aus dem Versorgungsnetz (201) bezieht, während der Wechselrichter (9) auf einer anderen Phase (L1, L2, L3) Leistung in das Versorgungsnetz (201) einspeist.

## Beschreibung

Die Erfindung betrifft einen Wechselrichter, insbesondere einer Photovoltaikanlage (PV-Anlage), der an ein Drei-Phasen-Drehstromversorgungsnetz zur Einspeisung regenerativ erzeugter Energie anschließbar ist.

Bei der Auslegung von Photovoltaikanlagen ist stets zu berücksichtigen, dass eine maximal zulässige Spannung (U_{z}) zwischen dem Pluspol und dem Minuspol an der Gleichstromseite eines Wechselrichters nicht überschritten wird. Ein Überschreiten würde zu einer Zerstörung des Wechselrichters und desjenigen Teils der Photovoltaikmodule führen, an welchem eine Spannung oberhalb der zulässigen Spannung anliegt.

Aus diesem Grund wird bei der Auslegung der Photovoltaikanlage üblicherweise sichergestellt, dass auch im ungünstigsten Fall eines Leerlaufs die Leerlaufspannung (U_{L} oder U₀) stets unterhalb der zulässigen Maximalspannung (U_{z}) liegt, weshalb in der Regel eine Vielzahl von Strängen parallel geschaltet wird. Die maximale Anzahl der Stränge richtet sich dabei nach der Leistung des Wechselrichters, an den die Stränge angeschlossen sind. Moderne Wechselrichter können bis zu einer Eingangsgleichspannung von ca. 900 Volt bis 1000 Volt ausgelegt sein.

Typischerweise ist jeder Strang der Photovoltaikanlage aus elf Photovoltaikmodulen aufgebaut, von denen jedes 120 Photovoltaikzellen aufweist. Insgesamt sind somit 1330 Zellen in Reihe zueinander geschaltet. An jeder Zelle liegt im Leerlauffall eine Spannung von 0,75 Volt an, was zu einer Strangspannung von 990 Volt führt, die unterhalb der von den Herstellern der Module angegebenen Maximalspannung von 1000 Volt liegt. Im Betrieb der Photovoltaikanlage sinkt die Leer-laufspannung der Zellen auf eine Betriebsspannung von ca. 0,5 Volt, so dass zwischen den Enden der herkömmlichen Stränge eine Spannung von 660 Volt anliegt. Sollte der Netzbetreiber, an den die Photovoltaikanlage angeschlossen ist, diese aus vom Netz nehmen, beispielsweise aufgrund eines Kurzschlusses im Einspeisekabel, so erhöht sich die Spannung sprunghaft auf die genannten 990 Volt, was für die Module und die Anlage unkritisch ist. Liegt eine höhere Spannung an, so kann dies zur Zerstörung eines Teils der Module, des Wechselrichters und der gesamten Anlage führen.

Andererseits ist es wünschenswert, insbesondere im Hinblick auf neuartige Wechselrichter mit höheren erlaubten Betriebs- und Leerlaufspannungen, die Photovoltaikmodule und auch den Wechselrichter im Normalbetrieb mit einer Spannung zu betreiben, die größer ist 660 Volt und vorzugsweise der zulässigen Höchstspannung von 1000Volt entspricht. Zur besseren Ausnutzung der in der Regel auf 1000Volt ausgelegten Isolationsfestigkeit der Verkabelung ist es zudem wünschenswert, die Anzahl der Module pro Strang zu erhöhen, um die 1000V-Spannung im Betrieb der Photovoltaikanlage auszunutzen. Dieses ist jedoch nicht ohne weiteres möglich, da dann im Fehlerfall eine Spannung von ca. 1500 Volt gegenüber Erde (Erdpotential) auftreten und zur Zerstörung der Photovoltaikmodule sowie der Leitungen führen könnte.

Zur Vermeidung dieser unzulässig hohen Spannungen ist es aus der DE 30 41 078 A1 und aus der DE 10 2005 018 173 A1 bekannt, zwischen dem Pluspol und dem Minuspol einen Kurzschlussschalter anzuordnen, der im Falle einer unzulässig hohen Spannung zwischen den Polen diese kurzschließt.

Aus der EP 2 086 020 A2 und aus der DE 20 2006 008 936 U1 ist es zudem bekannt, den Pluspol oder den Minuspol auf ein festes zulässiges Potential von z. B. 1000 Volt zu fixieren und die Photovoltaikanlage im Betrieb von diesem Potential aus nach unten oder nach oben schweben zu lassen, was auch als sogenanntes floaten bezeichnet wird.

Diese Maßnahme ist für Anlagen mit einem frei schwebenden Potential jedoch nicht möglich. Bei solchen Anlagen mit einem frei floatenden Potential des Plus-und des Minuspols treten z. B. Potentiale gegenüber einer virtuellen Erde von plus (+)600 Volt bis minus (-)600 Volt auf. Virtuelle Erde bedeutet dabei, dass die Stränge an keiner Stelle mit Erde verbunden sind. Würden jedoch die Strangmitte auf Erde gesetzt, so würden entsprechende Spannungen von (+)600 Volt des Pluspols und (-)600 Volt des Minuspols gegenüber der geerdeten Strangmitte anfallen. Für solche Anlagen könnte ein Schalter zwischen der Strangmitte und Erde vorgesehen sein, der im Falle eines Erdfehlers geschlossen wird und die Strangmitte real erdet. Im Ergebnis fallen dann lediglich noch Spannungen bis zu 600 Volt an den Modulen an. Diese Maßnahme wäre jedoch mit einem erheblichen Verkabelungsaufwand verbunden, da die Mitte jedes Stranges über den Schalter erreichbar sein muss. Bei der Verwendung von sogenannten TCO-Modulen treten darüber hinaus Korrosionsprobleme auf, da aufgrund von Kathodenentladung der der Modulrand erodiert wird.

Aus der DE 10 2009 025363 A1 ist ein Verfahren zur Vorbereitung der Netzsynchronisation eines Wechselrichters mit einer Photovoltaikanlage als Primärenergiequelle bekannt. Hierbei wird der vor Verbindung der Photovoltaikanlage mit dem Wechselrichter dieser von einer zweiten Energiequelle mit Energie versorgt und die Frequenz, die Phasenlage und die Ausgangsspannung des Wechselrichters an die Verhältnisse in einem Stromversorgungsnetz angepasst. Somit kann die Auslegung des Wechselrichters auf die zulässige Leerlaufspannung auch im Betriebsfall genutzt werden.

In der US 2005/121067 A1 ist eine Photovoltaikanlage mit einer Anzahl an Solarzellen offenbart, von denen jede mit jeweils einem zugeordneten Gleichrichter elektrisch verbunden ist. Mittels der Gleichrichter wird die elektrische Spannung angehoben und einem Wechselrichter zur Bereitstellung der Versorgung einer Last zugeführt.

Der Erfindung liegt die Aufgabe zugrunde, einen besonders geeigneten Wechselrichters an zugegeben, mittels dessen insbesondere eine Netzspannung stabilisiert ist, wobei geeigneterweise die Wirkleistung nicht reduziert ist. Des Weiteren soll ein besonders geeignetes Verfahren zum Betreiben eines Wechselrichters angegeben werden, bei dem insbesondere eine Netzspannung stabilisiert wird, wobei geeigneterweise die Wirkleistung nicht reduziert ist.

Bezüglich der PV-Anlage wird die genannte Aufgabe erfindungsgemäß gelöst durch die Merkmale des Anspruchs 1. Vorteilhafte Ausgestaltungen, Varianten und Weiterbildungen sind Gegenstand der hierauf rückbezogenen Unteransprüche.

Bezüglich des Verfahrens wird die genannte Aufgabe erfindungsgemäß gelöst durch die Merkmale des Anspruchs 6.

Eine Photovoltaikanlage mit einem Photovoltaikgenerator mit einer Anzahl von parallel angeordneten Strängen seriell verbundener Photovoltaikmodule, wobei die Stränge einen Pluspol und einen Minuspol aufweisen und zwischen den Polen eine anhand der Anzahl der Photovoltaikmodule vorgebbare Strangspannung anliegt, die im Leerlauffall des Photovoltaikgenerators größer als 1000Volt ist, und mit einem Wechselrichter, dessen Gleichspannungseingang mit den beiden Polen verbunden ist, und der ausgangsseitig mit einem Versorgungsnetz verbindbar ist, ist gekennzeichnet durch ein erstes Schaltelement zwischen dem Pluspol und Erde sowie ein zweites Schaltelement zwischen dem Minuspol und Erde, eine Messvorrichtung zur Erfassung der Spannung zwischen den Polen und Erde, und eine Steuervorrichtung zum Empfangen der gemessenen Spannungswerte von der Messeinrichtung und zum Auslösen von Steuersignalen zum zeitgleichen oder zeitversetzten Schließen der Schaltelemente, wenn die Spannung über dem ersten offenen Schaltelement einen ersten vorgegebenen Grenzwert übersteigt, oder wenn die Spannung über dem zweiten offenen Schaltelement einen zweiten vorgegebenen Grenzwert unterschreitet. Geeigneterweise beträgt der Zeitversatz zwischen 10ms und 100ms, insbesondere zwischen 20ms und 50ms. Beispielsweise ist der vorgegebene Grenzwert mindestens die Hälfte der vorgebbaren Strangspannung im Leerlauffall beträgt, wenn der Photovoltaikgenerator mit einem frei schwebenden Potential betrieben. Insbesondere sind der erste und der zweite Grenzwert betragsmäßig ungleich. Vorteilhafterweise sind der erste Grenzwert oder der zweite Grenzwert betragsmäßig mindestens 3% kleiner als die niedrigste zulässige Spannungsfestigkeit der beteiligten spannungsführenden Bauteile, insbesondere einer Klemme, eines Kabels und/oder des Photovoltaikmoduls. Vorzugsweise ist der zweite Grenzwert betragsmäßig mindestens 3% kleiner ist als die niedrigste im MPP-Regler, insbesondere in dessen Regelalgorithmus, hinterlegte Arbeitspunktspannung.

Der Betrieb der Photovoltaikanlage, die einen Photovoltaikgenerator mit einer Anzahl von parallel angeordneten Strängen seriell verbundener Photovoltaikmodule aufweist, wobei die Stränge einen Pluspol und einen Minuspol aufweisen und zwischen den Polen eine anhand der Anzahl der Photovoltaikmodule vorgebbare Strangspannung anliegt, die im Leerlauffall des Photovoltaikgenerators größer als 1000 Volt ist, und einen ausgangsseitig mit einem Versorgungsnetz verbundenen oder verbindbaren Wechselrichter aufweist, dessen Gleichspannungseingang mit den beiden Polen verbunden ist, ist dadurch gekennzeichnet, dass die Spannungen des Pluspols und des Minuspols gegenüber Erde gemessen und aus den gemessenen Werten ein erstes Steuersignal für ein zwischen dem Pluspol und Erde angeordnetes erstes Schaltelement sowie ein zweites Steuersignal für ein zwischen dem Minuspol und Erde angeordnetes zweites Schaltelement erzeugt werden, und dass bei Überschreiten eines Spannungswerts am ersten Schaltelement über einen ersten Grenzwert das erste Schaltelement geschlossen wird, und/oder dass bei Unterschreiten eines Spannungswerts am zweiten Schaltelement unter einen zweiten Grenzwert das Schaltelement geschlossen wird.

Dabei sind der Pluspol und der Minuspol über ein erstes beziehungsweise über ein zweites Schaltelement mit Erde verbindbar, wobei die Schaltelemente geschlossen werden, wenn die Spannung über dem ersten offenen Schaltelemente einen ersten vorgegebenen Grenzwert übersteigt oder wenn die Spannung über dem zweiten offenen Schaltelemente einen zweiten vorgegebenen Grenzwert unterschreitet.

Durch diese Maßnahme wird sichergestellt, dass an den Komponenten der PV-Anlage, insbesondere an den PV-Modulen und am Wechselrichter keine unzulässig hohe Spannung (Uz) gegen Erde im Leerlauffall auftritt. Durch die hohe Betriebsspannung von z. B. 1000Volt können bei gleicher Leistung der PV-Anlage Kabel mit dünneren Leitungsquerschnitten eingesetzt werden, was kostengünstiger ist und größere Anlagen erlaubt. Der Wechselrichter kann an dessen maximaler Spannung betrieben werden, wodurch eine bessere Ausnutzung der Dimensionierung des Wechselrichters, d. h. der Spannungsfestigkeit insbesondere der verbauten Kondensatoren, der elektronischen Bauelemente und der Verdrahtung erreicht wird. Darüber hinaus kann der Wechselrichter bei gegebenem Strom eine höhere Leistung in das Energieversorgungs- oder Stromnetz abgeben. Wird der Photovoltaikgenerator mit einem frei schwebenden Potential betrieben, so soll der Grenzwert mindestens die Hälfte der vorgebbaren Strangspannung im Leerlauffall betragen.

Es ist vorteilhaft, wenn der erste oder der zweite Grenzwert dem Betrage nach mindestens 3% kleiner ist bzw. sind als die niedrigste zulässige Spannungsfestigkeit aller beteiligten spannungsführenden Bauteile, wie z. B. einer Klemme, eines Kabels und des Photovoltaikmoduls. So richtet sich die Kurzschlussschaltung nach dem schwächsten Glied in der Kette, in der Regel nach dem Photovoltaikmodul oder bei älteren umgerüsteten Anlagen auch einer anderen Komponente.

Der zweite Grenzwert sollte dem Betrage nach mindestens 3% kleiner sein als die niedrigste, im Regelalgorithmus eines einer Photovoltaikanlage üblicherweise zugeordneten MPP-Reglers (Maximum Power Point Controller) niedergelegte Arbeitspunktspannung. Diese Maßnahme verhindert besonders zuverlässig, dass bei dem Einsatz von sogenannten TCO-Photovoltaikmodulen das Problem der Kathodenerosion bei negativem Potential, die TCO-Module weiterhin arbeiten und sich selbst zersetzen. Mit der erfindungsgemäßen Ausführung sind weitere Kurzschluss-Schaltelemente zwischen dem Pluspol und dem Minuspol der Gleichspannungsseite des Wechselrichters nicht erforderlich.

In Anlagen zur Erzeugung regenerativer Energie erzeugt jeder Photovoltaikgenerator (PV-Generator) einen Gleichstrom, der mittels des Wechselrichters in einen Wechselstrom umgewandelt wird. Als Wechselrichter können sowohl rein elektronische Geräte als auch elektromechanische Umformer eingesetzt werden. Unter Wechselrichter im sind dabei alle Vorrichtungen anzusehen, welche auf elektronischem Weg aus einer Gleichspannung eine Wechselspannung erzeugen können. So erzeugen Windkraftanlagen zwar unmittelbar einen Wechselstrom, der aber über einen Frequenzumformer an die Verhältnisse des öffentlichen Versorgungsnetzes anzupassen ist. Diese Frequenzumformer umfassen ebenfalls Wechselrichter mit einem internen Gleichstromzwischenkreis.

Bisher sind Maßnahmen zur Einhaltung der Stabilität eines mehrphasigen Drehstrom-Versorgungsnetzes bekannt, die auf das Netz gleichmäßig einwirken. Hier wurde als Nachteil erkannt, dass eine gemeinsame Spannungsveränderung aller Phasen zwar für eine der Phasen erforderlich oder zumindest dienlich sein kann, um die Unterschreitung oder die Überschreitung eines Spannungsschwellwertes zu verhindern, während für eine andere Phase des Drehstromnetzes dies eventuell eher unerwünscht ist. Wird z. B. eine Spannungsanhebung bewirkt, um eine drohende Unterspannung an einer Stelle im Netz zu verhindern, so kann an einer anderen Stelle, an der momentan keine großen Verbraucher anliegen, diese Spannungserhöhung eher unerwünscht sein.

Es ist daher eine erfindungsgemäße Überlegung, dass die Fähigkeit elektronischer Wechselrichter, auf jede Phase getrennt einzuwirken, für einen Beitrag zur Spannungsstabilisierung genutzt werden kann. Diese Geräte haben aufgrund deren inhärent vorhandenen Bauteile, wie z. B. IGBT's, die Möglichkeit, einen Leistungsbeitrag (VAr-Beitrag) phasenselektiv zu leisten. Es wird also eine bereits vorhandene Fähigkeit der Geräte zu einem weiteren Zweck genutzt.

Vorteilhafterweise kann die Stabilität in einem Versorgungsnetz durch eine Vergleichmäßigung der einzelnen Phasenspannungen erhöht werden, indem der Wechselrichter erfindungsgemäß einen Steuereingang aufweist, über den sein Betriebsmodus bei Anliegen eines Steuersignals derart veränderlich ist, dass eine bezüglich der drei Phasen unsymmetrische Einspeisung in das Versorgungsnetz erfolgt. Alternativ weist der Wechselrichter eine Steuer- und Regeleinheit auf, mittels der sein Betriebsmodus eine bezüglich der drei Phasen unsymmetrische Einspeisung in das Versorgungsnetz ermöglicht.

In vorteilhafter Ausgestaltung arbeitet der Betriebsmodus auf einen Punkt maximal erzeugbarer Leistung hin, die unsymmetrisch auf die drei Phasen verteilt wird.

Auch ist es zweckdienlich, wenn der Betriebsmodus auf einen Punkt maximal erzeugbarer Blindleistung oder auf einen Punkt beziehbarer Blindleistung hinarbeitet, die unsymmetrisch auf die drei Phasen verteilt wird. Ebenso ist es zweckdienlich, wenn der Betriebsmodus auf einen Punkt maximal erzeugbarer Leistung hinarbeitet und zusätzlich Blindleistung unsymmetrisch in die drei Phasen eingespeist oder unsymmetrisch von den drei Phasen bezogen wird. Auch kann es vorteilhaft sein, dass der Betriebsmodus hin zu dem maximalen Leistungspunkt ausgesetzt und in Abhängigkeit von dem Steuersignal ein vorgebbarer Betrag an Blindleistung in zumindest eine der drei Phasen eingespeist oder aus einer der drei Phasen bezogen wird.

Vorteilhafterweise wird die Spannung aller drei Phasen an einem beliebigen Netzverknüpfungspunkt im Versorgungsnetz gemessen, insbesondere an demjenigen Netzverknüpfungspunkt, der den Wechselrichter mit dem Versorgungsnetz verbindet, wobei das Steuersignal unter Zuhilfenahme der drei Spannungsmesswerte gebildet wird. Zur Bildung des Steuersignals ist es zweckmäßig, dass die Spannung von drei Phasen an dem Verknüpfungspunkt eines Transformators gemessen wird, und/oder dass der Strom an einem Netzverknüpfungspunkt gemessen wird, insbesondere an mindestens einem der Transformatorausgänge, und der Strommesswert in die Berechnung des Steuersignals eingeht.

Um einen höheren Bezug oder eine höhere Lieferung an Blindleistung an eine ausgewählte Phase beziehen oder liefern zu können, ist in einer vorteilhaften Weiterbildung des Verfahrens vorgesehen, dass die abgegebene Leistung P an der betreffenden Phase erhöht wird. Auch ist es zweckdienlich, dass zumindest bei einer der drei Phasen Blindleistung bezogen wird, während gleichzeitig an eine andere Phase Blindleistung geliefert wird, dass zumindest bei einer der drei Phasen Leistung bezogen wird, während gleichzeitig an eine andere Phase Leistung geliefert wird, dass zumindest bei einer der drei Phasen Blindleistung oder Leistung bezogen wird, während gleichzeitig an eine andere Phase Blindleistung oder Leistung geliefert wird, und/oder dass die Leistungsrichtung zumindest einer Phase von der Leistungsrichtung zumindest einer anderen Phase abweicht, während gleichzeitig auf zumindest einer Phase Blindleistung bezogen wird und zumindest an einer anderen Phase Blindleistung geliefert wird.

Ein derartiger Wechselrichter sowie ein solches Verfahren zu dessen Betrieb werden als eigenständige Erfindung angesehen.

Unter unsymmetrisch wird dabei verstanden, dass die erzeugte Leistung und/oder Blindleistung des Photovoltaikgenerators durch den Wechselrichter ungleich auf die drei Phasen aufgeteilt wird. Dies kann auch bedeuten, dass eine Phase oder zwei Phasen lediglich mit einem geringen oder keinem Anteil der erzeugten Leistung bedacht wird (werden) oder sogar Leistung aufnimmt (aufnehmen), während über mindestens eine andere Phase Leistung eingespeist wird. Die Erzeugung von Blindleistung ist dabei unabhängig von der Funktion des PV-Generators und kann auch nachts stattfinden, wenn keine Sonneneinstrahlung und keine Leistung vorhanden sind.

Bei einer Ermittlung aller drei Phasenspannungen L1, L2 und L3 ergeben sich zum Beispiel die Werte 230Volt, 225Volt und 228Volt. Dies kann in dem aktuell vorliegenden Verhalten von Verbrauchern oder auch durch eine Vielzahl von unabhängig voneinander in das Netz einspeisenden photovoltaischen Dachanlagen begründet sind. Dann ist einer vorsorglichen Netzstabilisierung dienlich, wenn die schwächste Phase L2, die lediglich eine Phasenspannung von 225Volt aufweist, gestärkt wird, indem in diese Phase die erzeugte Leistung über einen mit dem entsprechenden Steuereingang versehenen Wechselrichter eingespeist wird.

Bei großen Abweichungen kann der Wechselrichter auch freie Kapazitäten nutzen, um Blindleistung zur Spannungsanhebung in die Phase L2 einzuspeisen. Freie Kapazitäten des Wechselrichters liegen dann vor, wenn die momentan vorliegende Leistung des Photovoltaikgenerators unterhalb der Nennleistung des Wechselrichters liegt. Ist der Wechselrichter zum Beispiel auf 12kVA ausgelegt, werden jedoch aufgrund der herrschenden Sonneneinstrahlung lediglich 7KVA an Solarenergie generiert und in Wechselstrom gewandelt, so besitzt der betrachtete Wechselrichter eine freie Kapazität von 5KVA, die zur Blindleistungseinspeisung (VAr) zur Verfügung stehen. Diese Leistung von 5KVA entspricht der Differenz der aktuell gelieferten Leistung zur Nennleistung des Wechselrichters. So wird der Blindleistungsbetrag auf die zur Erreichung der Nennleistung des Wechselrichters verbleibende Leistung beschränkt. Dadurch wird die vom Energieerzeuger selber generierte Energie nicht eingeschränkt oder reduziert. Die freie Leistungskapazität des Wechselrichters wird lediglich zur Erfüllung einer weiteren Funktion, nämlich diejenige des Phasenschiebers oder Blindleistungslieferanten herangezogen. Üblicherweise ist der VAr-Betrag kleiner als der oben als Differenzbetrag errechnete VAr-Wert von 5kVA.

Über ein entsprechendes Steuersignal, das an den Steuereingang gelegt ist, wird die Anforderung umgesetzt. Dabei ist es unerheblich, ob an den Steuereingang lediglich die gemessenen Phasenspannungen gegeben werden, die dann von einer Recheneinheit im Wechselrichter zu einem Einspeisemodus umgesetzt werden, oder ob am Steuereingang direkt der geeignete Einspeisemodus eingegeben wird, den der Wechselrichter lediglich noch umsetzt.

Es kann zwischen vier grundsätzlichen Betriebsmodi unterschieden werden:
i) der Standardbetriebsmodus hin zu einem Punkt maximal erzeugbarer Leistung wird beibehalten und die photovoltaisch erzeugte Leistung wird unsymmetrisch auf die drei Phasen verteilt;
ii) es wird ein Betriebsmodus hin zu einem Punkt maximal erzeugbarer Blindleistung eingestellt, die unsymmetrisch auf die drei Phasen verteilt wird;
iii) der Standardbetriebsmodus hin zu einem Punkt maximal erzeugbarer Leistung wird vorrangig beibehalten, und zusätzlich wird freie Kapazität des Wechselrichters genutzt, um Blindleistung unsymmetrisch in die drei Phasen einzuspeisen oder unsymmetrisch von den drei Phasen zu beziehen;
iv) der Standardbetriebsmodus hin zu dem maximalen Leistungspunkt wird ausgesetzt und durch einen Betriebsmodus ersetzt, bei dem in Abhängigkeit von dem Steuersignal ein vorgebbarer Betrag an Blindleistung in zumindest eine der drei Phasen eingespeist oder aus einer der drei Phasen bezogen wird.

Der Standardbetriebsmodus hin zu dem Punkt maximaler Leistung ist an sich bekannt und es soll darauf hier nicht weiter eingegangen werden. Wichtig ist für das Ziel vorliegenden Wechselrichters, dass dieser ein Steuersignal in eine unsymmetrische Verteilung seiner Leistung umsetzen kann, und/oder dass seine elektronischen Komponenten über das Steuersignal derart beeinflusst werden, dass zusätzlich Blindleistung generiert werden kann.

Bezüglich eines geeigneten Verfahrens zum Betrieb des Wechselrichters ist es vorteilhaft, dass die Spannung von allen drei Phasen an einem beliebigen Netzverknüpfungspunkt im Versorgungsnetz, insbesondere an demjenigen Netzverknüpfungspunkt, der den Wechselrichter mit dem Versorgungsnetz verbindet, gemessen wird, und dass das Steuersignal unter Zuhilfenahme der drei Spannungsmesswerte gebildet wird.

Unter dem Netzverknüpfungspunkt wird die Position der Zählstelle zwischen dem Verbraucher und dem Netz sowie zwischen dem Einspeiser und dem Netz verstanden. Vorliegend wird hierunter auch jede Position innerhalb des öffentlichen Versorgungsnetzes sowie des Netzes der Verbraucher und der Einspeiser, an denen die Spannungsmessung vorgenommen wird, verstanden.

Die Wahl des Messpunktes in unmittelbarer Nähe des Wechselrichters bedeutet eine spontane Korrekturmöglichkeit der drei Phasenspannungen am Ort der Maßnahme. Zusätzlich zu diesem Ort sind alle Netzverknüpfungspunkte besonders geeignet, an denen eine hohe Spannungssensibilität herrscht. Dies bedeutet, dass ein besonders geeigneter Ort für die Platzierung der Spannungsmessvorrichtung am Ende einer Stichleitung oder in Bezug zu einem eine Ringleitung speisenden Netztransformator in der Mitte der Ringleitung oder bei mehreren einspeisenden Transformatoren in deren Nähe ist. Dort befinden sich die Verbraucher, die in der normalen Bezugsrichtung des Netzes die niedrigste Netzspannung mit der größten Differenz ihrer Phasenspannungen zur Verfügung haben, insbesondere wenn einer der Transformatoren ausfällt, z. B. wegen Wartungsarbeiten. Aufgrund der vor ihnen liegenden anderen Verbraucher, die alle einen marginalen Spannungsabfall bewirken, ist dort die verfügbare Spannung in der Regel am niedrigsten, es sei denn, dass ein Energielieferant in der Nähe ist.

Am Ende einer Stichleitung und in Bezug zu einem eine Ringleitung speisenden Netztransformator in der Mitte der Ringleitung sind dabei relativ zu sehen. Ist zum Beispiel eine Stichleitung mit 200 Anknüpfungspunkten gegeben, so ist das Ende als ein Anknüpfungspunkt von den letzten 10%, also als einer der letzten 20 Anknüpfungspunkte zu sehen. Analog wären bei einer Ringleitung von 200 Anknüpfungspunkten die jeweils 10 links und rechts der Transformator-Verknüpfungspunkte liegenden Anknüpfungspunkte zu sehen.

Es wird generell der spannungssensibelste Netzverknüpfungspunkt, insbesondere unter der Hypothese eines Transformatorausfalls, gewählt. Dies kann auch eine andere Stelle sein, wenn dort z.B. ein Verbraucher angeordnet ist, der schwere Maschinen mit hohem Anlaufstrom betreibt, die am Tag häufig an- und abgeschaltet werden. Alternativ wird der Verbraucher mit der höchsten Schwankungsbreite beim Blindleistungsbezug ermittelt, und die Messung des Spannungswerts erfolgt am Netzverknüpfungspunkt dieses Verbrauchers.

Generell ist der spannungssensibelste Punkt geprägt durch die höchste Spannungsvariation in Bezug zu einer einspeisenden oder zu beziehenden Leistung P. Ferner kann die Spannungsvariation durch einen prozentualen Veränderungsbetrag und nicht durch die absoluten betrachteten Spannungswerte definiert werden. Dies ist bei Vorliegen einer Ringleitung meist in der Mitte in Bezug zum Transformator zum nächst höheren Netz der Fall, das heißt an derjenigen Stelle, an der in beiden Richtungen die gleiche Entfernung zum Transformator besteht. Daraus folgt, dass zur Bildung des Steuersignals die Spannungsmessung von mindestens zwei Phasen an dem Verknüpfungspunkt eines Transformators besonders geeignet ist. Zusätzlich sollte der Strom durch mindestens einen der Transformatorausgänge gemessen und verwendet werden, um in die Berechnung des Steuersignals einzugehen.

Geeigneterweise werden die Betriebsführung des Wechselrichters durch die ihm inhärente Regeleinrichtung auf den maximalen Leistungspunkt MPP des Photovoltaikgenerators oder der Windkraftanlage beibehalten und vom Wechselrichter zusätzlich eine solche Blindleistungsmenge in die Versorgungsebene eingespeist oder daraus bezogen, die maximal der Differenz der aktuell gelieferten Leistung zur Nennleistung des Wechselrichters entspricht.

Bei geeigneter Betriebsführung des Wechselrichters führt eine gemessene Phasenspannung unterhalb eines Schwellwerts zu einer Einspeisung von Blindleistung in diese Phase seitens des Wechselrichters, während eine drohende Überspannung einer Phase, z.B. bei Erreichen eines oberen Schwellwerts, zu einem Bezug von Blindleistung aus gezielt dieser Phase durch den mindestens einen Wechselrichter führt.

Bei einigen Energieversorgern kann es vorgeschrieben sein, dass ein festes Verhältnis von Leistung zu Blindleistung, also entsprechend ein fester cos phi Wert, beibehalten wird. Gegebenenfalls ist es zweckmäßig, die abgegebene Leistung P an der betreffenden Phase zu erhöhen, um einen höheren Bezug oder eine höhere Lieferung an Blindleistung an eine ausgewählte Phase zu beziehen oder liefern zu können. Damit wird auch über den festen cos phi Wert die Blindleistung an dieser ausgewählten Phase entsprechend verändert.

Im Zuge der unsymmetrischen Verteilung kann auch die Richtung der Blindleistungserzeugung von Phase zu Phase variieren. So kann es zweckmäßig sein, dass zumindest bei einer der drei Phasen Blindleistung bezogen wird, während gleichzeitig an eine andere Phase Blindleistung geliefert wird. Dies kann beliebig modifiziert werden, in dem z.B. an zwei Phasen Blindleistung geliefert wird und von der dritten Phase Blindleistung bezogen wird, oder es wird von zwei Phasen Blindleistung bezogen und an die dritte Phase geliefert usw. Dies bedeutet die Schaffung der Möglichkeiten: i) dass zumindest bei einer der drei Phasen Blindleistung oder Leistung bezogen wird, während gleichzeitig an eine andere Phase Blindleistung oder Leistung geliefert wird, und ii) dass die Leistungsrichtung zumindest einer Phase von der Leistungsrichtung zumindest einer anderen Phase abweicht, während gleichzeitig auf zumindest einer Phase Blindleistung bezogen wird und zumindest an einer anderen Phase Blindleistung geliefert wird.

Ein besonders geeignetes Verfahren zur Optimierung der Einspeiseleistung und der Stabilität in einem öffentlichen Stromversorgungsnetz mit mehreren Energielieferanten von regenerativer Energie, bei dem jeder Energielieferant einen auf der Basis elektronischer Bauelemente arbeitenden Wechselrichter aufweist, sieht erfindungsgemäß vor, dass jeder Wechselrichter seine momentan frei verfügbare Blindleistungskapazität an eine Systemsteuerung meldet, die aus den eingegangenen Daten zur Blindleistungskapazität einen Beitrag für jeden Energielieferanten ermittelt, den dieser über seinen Wechselrichter als Blindleistung in das Versorgungsnetz einspeist oder aus dem Versorgungsnetz bezieht. Eine zweckmäßige Weiterbildung dieses Verfahrens sieht vor, dass jeder Wechselrichter die momentan eingespeiste Leistung als Prozentwert seiner Nennleistung meldet.

Gemäß einer alternativen Ausführungsform ist erfindungsgemäß vorgesehen, dass jeder Wechselrichter seine momentan in das Versorgungsnetz eingespeiste Leistung an eine Systemsteuerung meldet, die aus den eingegangenen Daten zur Leistung einen Beitrag für jeden Energielieferanten ermittelt, den dieser über seinen Wechselrichter als Blindleistung in das Versorgungsnetz einspeist oder aus dem Versorgungsnetz bezieht. Eine zweckmäßige Weiterbildung dieses Verfahrens sieht vor, dass jeder Wechselrichter die momentan eingespeiste Leistung als Prozentwert seiner Nennleistung meldet, dass jeder Wechselrichter die momentan eingespeiste oder bezogene Blindleistung als Prozentwert seiner Nennleistung meldet.

Geeigneterweise ist die Systemsteuerung in einem der Wechselrichter integriert oder befindet sich einer Leitwarte. Vorzugsweise ist in der Systemsteuerung die Nennleistung der Wechselrichter der beteiligten Energielieferanten hinterlegt. Zweckmäßig wird zusätzlich zu den Daten der Kapazität die freie Reserve bis zum Erreichen der Nennleistung des Wechselrichters an die Systemsteuerung gemeldet. Auch ist es vorteilhaft, dass die Wechselrichter der mehreren Energielieferanten Netzbereichen und Spannungsebenen zugeordnet werden. Geeigneterweise wird die geographische Lage der Energielieferanten in die Ermittlung mit einbezogen. Besonders bevorzugt werden sowohl die frei verfügbare Kapazität zur Lieferung oder zum Bezug von Blindleistung und die geographische Lage der Energielieferanten als auch die Zuordnung der Energielieferanten zu einem Netzbereich in die Ermittlung einbezogen, um durch eine definierte Einspeisung/Bezug von Blindleistung die höchste Wirksamkeit bei der Spannungsstabilisierung zu erreichen.

Obwohl das Ziel dieses Verfahrens, dass als eigenständige Erfindung angesehen wird, die Stabilisierung des Versorgungsnetzes mittels der Aufteilung und Verteilung der Blindleistungsbeiträge auf die beteiligten Lieferanten alternativer Energie ist, kann auch eine Meldung der momentanen Leistung zum Ziel führen. Dies ist z. B. der Fall, wenn die Steuer- und Regeleinheit des betreffenden Energielieferanten den Wechselrichter auf einen festen cos phi Wert fährt, womit aus der Kenntnis der Leistung ein Rückschluss auf die momentane Blindleistung gezogen werden kann. Bei Kenntnis der Nennleistung der einzelnen Energielieferanten kann dann die frei verfügbare Blindleistungskapazität ermittelt werden.

Die erzielten Vorteile bestehen insbesondere darin, die zuvor genannte Eigenschaft von Wechselrichtern zur Stabilisierung der Netzspannung zu nutzen, ohne eine Reduktion der Wirkleistung in Kauf nehmen zu müssen oder eine Einspeisung dieser gegebenenfalls sogar zu steigern.

So werden in der Praxis der öffentlichen Stromversorgung je nach Versorgungsebene von den Energieversorgungsunternehmen mehr oder weniger enge Grenzen für den Blindleistungsbezug oder die Blindleistungslieferung der Stromlieferanten und der Stromverbraucher gesetzt. In den meisten Ländern beträgt der zulässige cos phi Wert für einen sanktionslosen Blindleistungsbezug oder eine Blindleistungseinspeisung 0,95. Diese Maßnahme dient der Stabilisierung der Netze, um eine Überspannung, die zu einer Zerstörung von angeschlossenen Verbrauchern führen kann, und eine Unterspannung, die zu einem Versagen von Verbrauchern führen kann, zu vermeiden. Als Regulativ zur Einhaltung der gesetzten cos phi Werte dient der Preis. So wird eine Einspeisung oder ein Bezug von Blindleistung außerhalb der von dem Energieversorger oder Obernetzbetreiber vorgegebenen Bandbreite für den cos phi mit erheblichen Aufzahlungen belegt.

In Anlagen zur Erzeugung regenerativer Energie erzeugt jede Photovoltaikanlage in ihrem PV-Generator einen Gleichstrom, der mittels eines Wechselrichters in einen Wechselstrom umgewandelt wird. Die elektronischen Komponenten eines Wechselrichter, ebenso wie auch die Kombination einer Gleichstrommaschine mit einem Synchrongenerator als mechanischen Wechselrichter, erlauben die Einstellung eines gewünschten cos phi Wertes in Bezug zur Leistung. Dies geschieht bei den meisten PV-Anlagen durch einen cos phi - Zeiger, über den ein festes Verhältnis von eingespeister Leistung zu eingespeister oder bezogener Blindleistung eingestellt werden kann. So wird der Regeleinheit z. B. vorgeschrieben, jegliche in das Netz eingespeiste Leistung mit einem cos phi von 0,97 einzustellen.

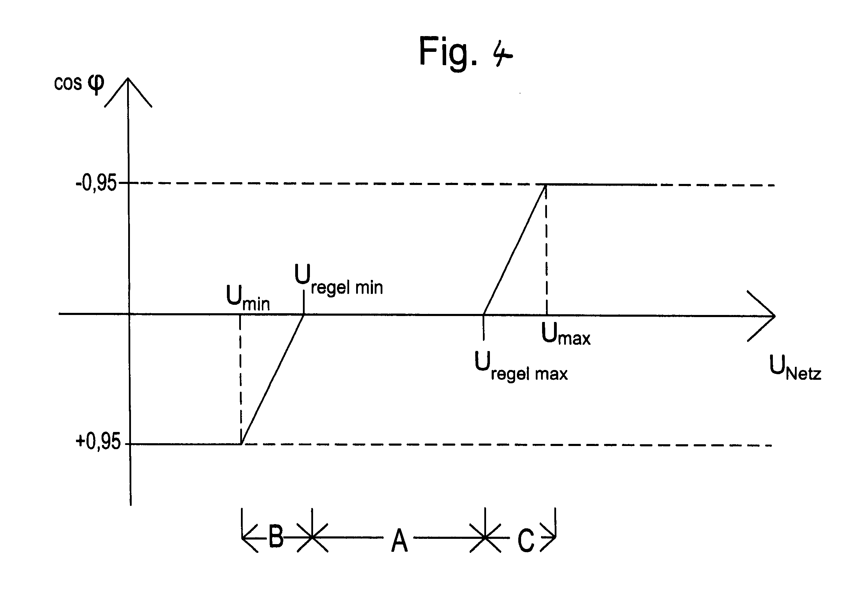

Bei größeren und modernen Anlagen ist es üblich, den cos phi Wert nicht starr als Zeiger vorzugeben, sondern nach dem Diagramm entsprechend der Fig. 4 einzustellen. Dort ist ein einzustellender cos phi-Wert am Ausgang des Wechselrichters über die Netzspannung aufgetragen. Die Ausgangsspannung U_{Netz} zur Einspeisung in das Netz darf nur innerhalb eines minimalen Werts Uₘᵢₙ und eines maximalen Werts Uₘₐₓ variieren. Außerhalb dieses vom Energieversorger zugelassenen Bereichs der Einspeisung ins Netz mit einem cos phi von z.B. maximal 0,95 sollte die Photovoltaikanlage nicht betrieben werden. Innerhalb dieses zulässigen Bereichs liegt ein engerer Bereich zwischen einer minimalen Regelspannung U_{regel min} und einer maximalen Regelspannung U_{regel max}, in welchem reine Leistung ohne eine Blindleistungskomponente an das Netz abgegeben werden kann. In der Mitte dieses engeren Bereichs liegt die Sollspannung Uₛₒₗₗ.

In der Regel sind Energieversorger vor allem hinsichtlich deren Vertragsverhältnis zum Obernetzbetreiber (e.g. Atomkraftwerk, Kohlekraftwerk etc. als Energielieferant) dazu verpflichtet, einen Blindleistungsbezugswert von cos phi 0,95 nicht zu überschreiten, um die Spannungsstabilität in dem überregionalen Obernetz sicher zu stellen. Das bedeutet, dass in dem Zahlenbeispiel ein cos phi Wert von 0,94 eine Überschreitung des Bezugs darstellt, wohingegen eine cos phi Wert von 0,96 eine Unterschreitung, dass heißt ein nicht Ausnutzen des maximal erlaubten Bezugs, darstellt. Ein Bezug oder die Lieferung von Blindleistung ist aber oftmals in den unteren Netzen erforderlich, um einen Spannungsanstieg durch die Einspeisung von Solar- und Windkraftstrom zu kompensieren bzw. um einen Spannungsabfall durch ausfallende Lieferung von alternativ erzeugter Energie oder das Anfahren von Maschinen zu kompensieren.
Elektronische Wechselrichter können durch entsprechende Ansteuerung deren IGBT's von sich aus Blindleistung erzeugen, die diese in das angeschlossene Versorgungsnetz einspeisen können. Ebenso kann eine Ansteuerung derart erfolgen, dass Blindleistung aus dem Netz bezogen wird. Der Bezug von Blindleistung wirkt dabei netzseitig spannungsreduzierend und das Einspeisen von Blindleistung spannungserhöhend.

Das erfindungsgemäße Verfahren ermöglicht besonders vorteilhaft, die zuvor genannte Eigenschaft von Wechselrichtern zur Stabilisierung der Netzspannung zu nutzen, ohne eine Reduktion der Wirkleistung in Kauf nehmen zu müssen oder eine Einspeisung dieser gegebenenfalls sogar zu steigern. Der Vorteil der oben genannten Maßnahmen sollen an einem Beispiel erläutert werden. Dabei wird die folgende Begriffsbildung verwendet: Eine Photovoltaikanlage besteht aus einem PV-Generator und einem Wechselrichter. Es sind drei größere Photovoltaikanlagen an das öffentliche Versorgungsnetz angeschlossen. Das Netz ist in einem Betriebszustand, der zur Sicherstellung der Stabilität Maßnahmen erfordert. Mögliche Gründe können dabei der Ausfall eines Transformators wegen Wartungsarbeiten, das Anfahren von Induktionsöfen, die Einspeisung von zahlreichen Photovoltaikanlagen auf Dächern mit einer jeweils einhergehenden kleinen flukturierenden Spannungserhöhungen etc. sein.

Die drei Photovoltaikanlagen befinden sich an unterschiedlichen Orten, die weit auseinanderliegen, so dass ein vorliegendes Wolkenbild zu jeweils unterschiedlicher Sonneneinstrahlung auf die einzelnen PV-Generatoren führt, was unweigerlich zu einer unterschiedlichen Einspeisung von Energie durch die Wechselrichter in das Stromnetz führt. Die erste Photovoltaikanlage wird z.B. unter Volllast betrieben, das heißt, ihr zugehöriger Wechselrichter arbeitet mit seiner Nennleistung, um elektrische Energie in das Versorgungsnetz einzuspeisen. Die beiden andern PV-Anlagen erzeugen zur selben Zeit lediglich 70% beziehungsweise 80% ihrer Nennleistung, die von den zugordneten Wechselrichtern in das Versorgungsnetz eingespeist wird.

Erfindungsgemäß werden der- oder diejenigen Wechselrichter zum Bezug oder zur Einspeisung von Blindleistung herangezogen, die freie Blindleistungskapazitäten haben, deren Nennleistung also momentan nicht ausgeschöpft ist, um anderen Energielieferanten oder-erzeugern zu ermöglichen, zusätzliche Wirkleistung in das Versorgungsnetz einzuspeisen. Bei obigem Beispiel sind die zweite und die dritte Photovoltaikanlage in der Lage, Spannungsstabilisierende Blindleistungsbeiträge zu leisten. Da der Wechselrichter der ersten Photovoltaikanlage auf Volllast arbeitet und keine weitere Leistung mehr verarbeiten kann, ohne seine Blindleistungsverpflichtung gegenüber dem Netzbetreiber zu missachten, kann sein Blindleistungsanteil zurückgenommen werden, wenn der mit dem Blindleistungsanteil einhergehende Stabilisierungseffekt von einer anderen Photovoltaikanlage mit übernommen wird.

Der bei der ersten Photovoltaikanlage durch die Zurücknahme der Blindleistung frei werdende Beitrag kann zur Erhöhung der Einspeisung von Wirkleistung genutzt werden. Erfindungsgemäß ist daher eine Optimierung der Blindleistungseinspeisung oder deren Bezug zwischen verschiedenen Energielieferanten (Energieerzeugern) mit dem Ziel gegeben, gemeinsam die maximale Leistung beziehungsweise die maximale Anzahl an Kilowattstunden in das Versorgungsnetz einzuspeisen unter gemeinsamer Betrachtung aller Energielieferanten und nicht isoliert nur eines einzigen Energielieferanten. Hierbei ist es sinnvoll, wenn Geräte mit temporär niedriger vorliegender Leistung und freier VAr-Regelkapazität (Leistungs- bzw. Blindleistungskapazität) mehr zur Netzstützung beitragen als Energielieferanten mit einer zum selben Zeitpunkt hohen vorliegenden Leistung und niedriger Blindleistungsregelkapazität. Das entspricht einer Übernahme von VAr-Regelanforderungen durch Energieerzeuger, die momentan dazu in der Lage sind, ohne ihre Leistung reduzieren zu müssen. Es werden quasi freie VAr-Kapazitäten verschoben, um eine Nachfrage und ein Angebot zum Nutzen einer maximal möglichen Leistung bei Einhaltung der Netzspannung innerhalb eines vorgebbaren Bereichs auszutarieren.

Die Zuordnung von Energielieferanten (Energieerzeugern) in Netzbereiche, Spannungsebenen und die Einbeziehung deren geographischer Lage zueinander ermöglichen einen sicheren Betrieb und optimiert den Wirkeffekt von Blindleistungseinspeisung oder -bezug hinsichtlich der Spannungsstabilisierung im Netz unter gleichzeitiger Optimierung des Gesamtsystems aller Energielieferanten, die maximale Anzahl der Kilowattstunden (kWh) in das Netz einzuspeisen.

Nachfolgend werden Ausführungsbeispiele der Erfindung anhand einer Zeichnung näher erläutert. Darin zeigen:
- Fig. 1: schematisch Photovoltaikanlage (PV-Anlage) mit zeitversetztem Kurzschließen des Plus- und Minuspols; und
- Fig. 2: schematisch vereinfacht eine weitere Ausführungsform einer erfindungsgemäßen PV-Anlage mit synchronem Kurzschließen des Plus-und Minuspols,
- Fig. 3: eine schematische Übersicht einer Photovoltaikanlage mit einem Wechselrichter,
- Fig. 4: ein Regelschema eines Wechselrichters einer Solaranlage zur Einstellung eines cos phi Werts über die Ausgangsspannung, und
- Fig. 5: eine schematische Darstellung eines Versorgungsnetzes.

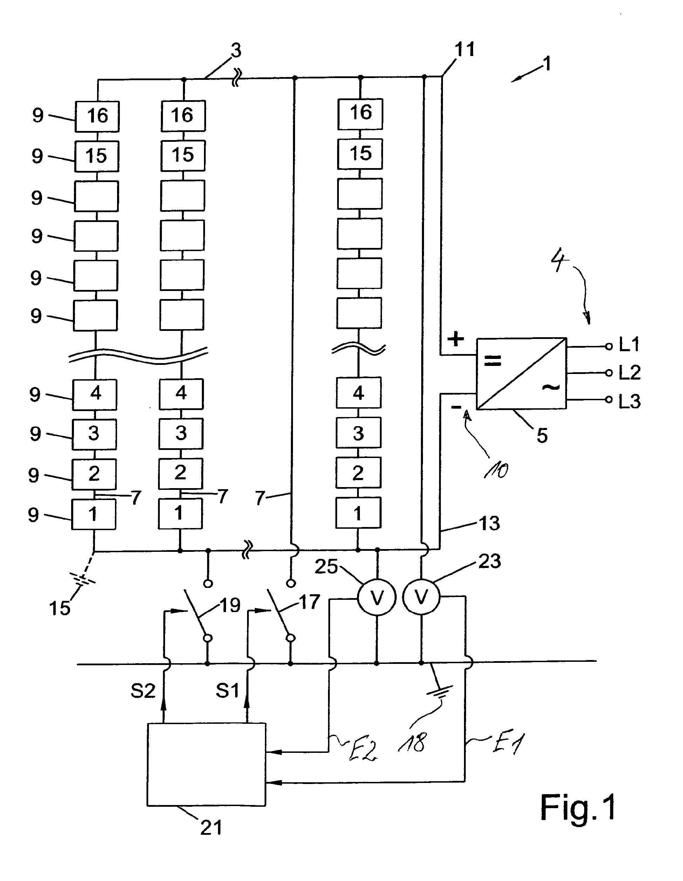

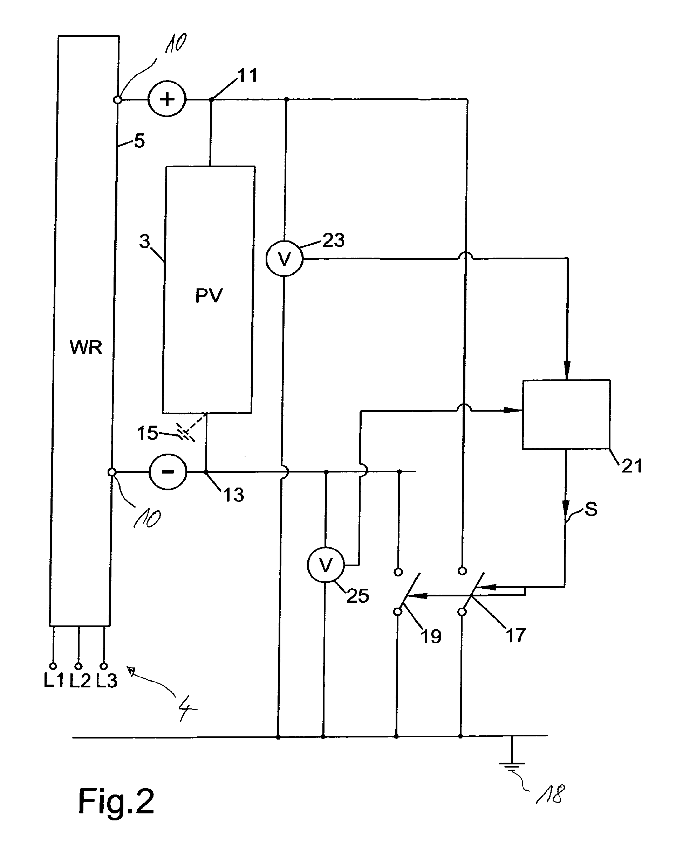

Eine nachfolgend als PV-Anlage bezeichnete Photovoltaikanlage 1 weist gemäß den Fig. 1 und 2 als wesentliche Elemente einen nachfolgend als PV-Generator bezeichneten Photovoltaikgenerator 3 und einen Wechselrichter 5 auf. Der an ein dreiphasiges (L1, L2, L3) Versorgungsnetz 4 angeschlossene PV-Generator 3 weist eine Anzahl parallel geschalteter Stränge 7 auf, die jeweils aus einer Reihenschaltung von sechzehn (16) nachfolgend als PV-Modulen bezeichneten Photovoltaikmodulen 9 bestehen. Die Enden der Stränge 7 bilden einerseits einen Pluspol 11 und andererseits einen Minuspol 13.

Gemäß dem einleitend angeführten Beispiel zurückzugreifen, bei dem ein PV-Modul 9 zu jeweils einhundertzwanzig (120) Zellen vorgestellt wurde, von denen jede eine Betriebsspannung von 0,5V und eine Leerlaufspannung von 0,75V aufweist, ergibt sich für jeden Strang 7 eine Leerlaufstrangspannung zwischen dem Pluspol 11 und dem Minuspol 13 in Höhe von 1440V. Im Betrieb des PV-Generators 3 stellt sich eine Betriebsspannung zwischen den Polen 11 und 13 in Höhe von 960V ein. Die Betriebsspannung ist für die PV-Module 9 und den Wechselrichter 5 ungefährlich und nutzt die zulässige Spannungsgrenze von 1000V gut aus. Bei einem Abschalten des PV-Generators 3 vom Netz 4 wird über entsprechende Maßnahmen vermieden, dass die Leerlaufspannung von 1440V, die zu Schäden führen kann, an den PV-Modulen 9 und dem Gleichspannungseingang 10 des Wechselrichters 5 anliegt. Bleibt die Leistungsabgabe an der Wechselspannungsseite 8 des Wechselrichters 5 unbeabsichtigt ungeplant aus, so erhöht sich die Eingangsspannung an der Gleichspannungsseite (Gleichspannungseingang 10) sprunghaft auf den Wert der Leerlaufspannung, was zu vermeiden ist.

Eine andere, ungeplante Spannungserhöhung kann durch einen Erdschluss oder einen schleichenden Erdfehler 15 auftreten, der an einer der Verbindungsleitungen zwischen den PV-Modulen 9, zwischen den Strängen 7 oder zum Wechselrichter 5 auftritt. Ein solcher Erdfehler 15 ist in den Figuren durch ein gestrichelt ausgeführtes Massezeichen symbolisiert. Zur besseren Verständlichkeit ist der Erdfehler 15 unten am ersten PV-Modul 9 eingezeichnet. An jeder anderen Stelle führt der Erdfehler 15 im Prinzip - lediglich vergleichsweise geringfügig schleichender - zu demselben Effekt.

Der Erdfehler 15 ist in der Regel kein belastbarer Kurzschluss, sondern bewirkt einen reduzierten Übergangswiderstand zur Masse, der aber ausreicht, um das Potential an diesem Punkt zu verschieben. Die Verschiebung hat zur Folge, dass im Leerlauffall der Minuspol 13 in Richtung Masse verlegt ist. Aus Gründen der Anschaulichkeit wird von einem nicht strombelastbaren Masseschluss ausgegangen. Tritt ein Leerlaufzustand auf, so würde sich am ersten PV-Modul 9 unten eine Leerlaufspannung von 90V aufbauen, bei dem darüber liegenden zweiten PV-Modul 9 von 180Vlt, bei dem nächsten PV-Modul 9 von dreimal 90V, also 270V etc. Von PV-Modul 9 zu PV-Modul 9 erhöht sich die Spannung am PV-Modul 9 um 90V, was ab dem zwölften Modul zu einer unzulässigen Spannung von 1080V führt.

Erfindungsgemäß ist nun sowohl am Pluspol 11 ein erstes Schaltelement 17 als auch am Minuspol 13 ein zweites Schaltelement 19 vorgesehen ist, von denen bei Anliegen eines Steuer- oder Schaltsignals S1 am ersten Schaltelement 11 der Pluspol 11 mit Erde oder Masse 18 verbunden wird. Analog wird bei Anliegen eines Steuer- bzw. Schaltsignals S2 am zweiten Schaltelement 19 der Minuspol 13 mit Erde bzw. Masse 18 verbunden.

Die Schaltsignale S1 und S2 werden von einer Steuervorrichtung 21 generiert, der als Eingangssignal E1 der von einer am Pluspol 11 angeschlossenen ersten Messvorrichtung 23 ermittelte, am Pluspol 11 anliegende Spannungswert sowie der von einer am Minuspol 13 angeschlossenen zweiten Messvorrichtung 25 ermittelte, am Minuspol 13 anliegende Spannungswert als Eingangssignale E2zugeführt wird.

Der Schließvorgang der Schaltelemente 17, 19 ist dabei derart gesteuert, dass die erste Messvorrichtung 23 zunächst einen Spannungswert oberhalb eines Grenzwertes G1 von z. B. 1000V ermittelt. Dies wird von der Steuervorrichtung 21 erkannt, die daraufhin ein Schaltsignal S1 an das erste Schaltelement 17 abgibt, woraufhin dieses schließt. Aufgrund der Verbindung des Pluspols 11 zur Masse 18 wird die Spannung am Minuspol 13 nach unten verschoben, da die anliegende PV-Generatorspannung von Masse 18 ausgehend hin zu einem kleineren Potential führt. Die Verschiebung nach unten führt dazu, dass ein zweiter Grenzwert G2 für das Auslösen des Schaltsignals S2 zum Schließen des zweiten Schaltelements 19 unterschritten wird. Daraufhin schließt das zweite Schaltelement 19 und auch der Minuspol 13 des Photovoltaikgenerators 3 wird auf Masse 18 gelegt.

Somit ist der Photovoltaikgenerator 3 insgesamt kurzgeschlossen und keines der beteiligten Bauelemente des PV-Generators 3, insbesondere Befestigungsklemmen, Kabel, Kabelverzweigungen, Kabelschuhe oder Photovoltaikmodule 9 führt weiterhin Spannung. Die beiden Schaltsignale S1 und S2 werden also zeitversetzt erzeugt, wobei das Kurzschließen eines der beiden Pole 11 oder 13 automatisch zu einem sich zeitlich anschließenden Kurzschließen des jeweils anderen Poles 13 bzw. 11 führt. Schließt demnach zuerst das zweite Schaltelement 19 aufgrund einer von der zweiten Messeinrichtung 25 ermittelten Unterschreitung der unteren Grenzspannung G2 von z. B. minus (-) 850V, so führt der belastbare Masseschluss zu einem Anheben des Potentials am Pluspol 11 des PV-Generators 3 über den diesem zugeordneten ersten Grenzwert G1, wobei die Überschreitung des ersten Grenzwerts G1 die Erzeugung des zweiten Schaltsignals S2 zur Folge hat. Die Schaltelemente 17, 19 sind daher bevorzugt derart ausgelegt, dass die Zeitspanne zwischen der Erzeugung der beiden Schaltsignale S1 und S2 zwischen 10ms und 100ms, insbesondere zwischen 20 ms und 50 ms, beträgt.

In Fig. 2 ist der Photovoltaikgenerator 3 aus Gründen der Übersichtlichkeit als Block dargestellt. Der Photovoltaikgenerator 3 besteht aus den gleichen Komponenten wie der Photovoltaikgenerator 3 gemäß der Fig. 1. Der Unterschied der Photovoltaikanlage 1 nach der Fig. 2 besteht darin, dass von der Steuervorrichtung 21 anstelle der beiden zeitversetzt erzeugten Schaltsignale S1 und S2 nur ein einziges Steuer- bzw. Schaltsignal S erzeugt wird, welches zu einem synchronen Auslösen der beiden Schaltelemente 17, 19 führt.

Es sind Schaltelemente 17, 19 verfügbar, die auch hohe Gleichströme von mehreren hundert Ampere bei zwei physisch getrennten Leitungen zeitgleich schalten können. Die Schaltelemente 17, 19 können dabei auf chemischer, elektrischer oder mechanischer Grundlage arbeiten und insbesondere Varistoren oder IGBTs sein.

Der erste und der zweite Grenzwert G1 bzw. G2 können über nicht gezeigte Einstellmittel an der Steuervorrichtung 21 eingestellt werden. Auch können vorbestimmte Grenzwerte herangezogen werden, die in der Steuervorrichtung 21 fest vorprogrammiert sind und mit den Messwerten der ersten und der zweiten Messvorrichtung 23, 25 verglichen werden. Zudem kann anstell der beiden Messvorrichtungen 23, 25 eine einzelne Messvorrichtung vorgesehen sein.

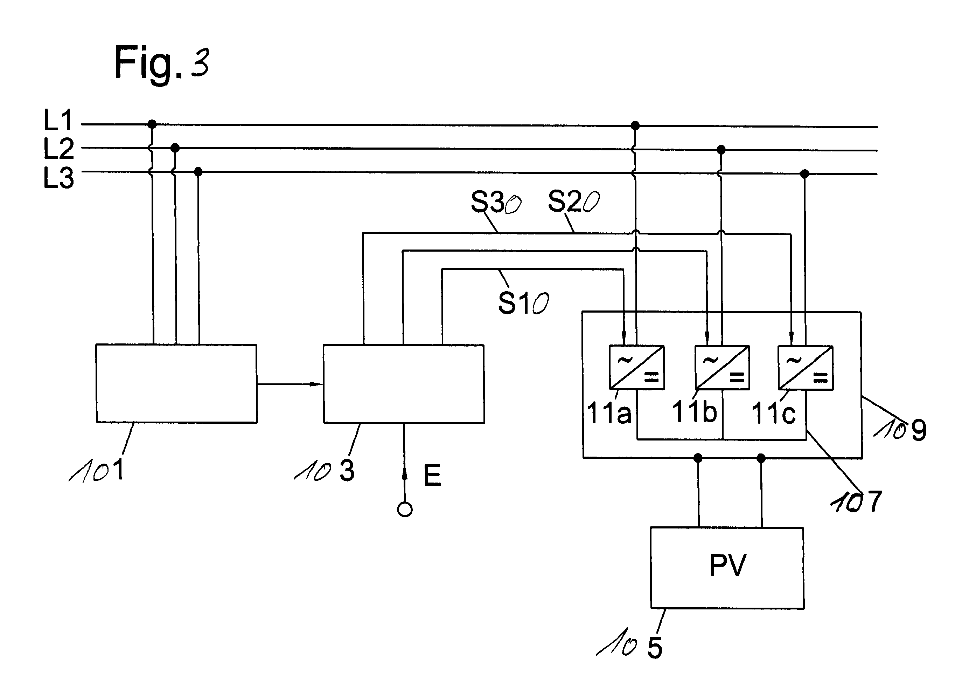

In Fig. 3 ist ein Dreileiterstromversorgungssystem mit den Leitern L1,L2,L3 gezeigt, die an eine Messstelle 101 angeschlossen sind, mit deren Hilfe zumindest die anliegende Spannung an den einzelnen Phasen L1,L2,L3 gemessen wird. Es ist auch denkbar, zusätzlich den Stromwert durch die Leiter zu ermitteln, um eventuell eine Überbelastung eines Leiters zu erkennen, und dann z.B. die eigene Einspeiseleistung auf nicht voll ausgelastete Leiter zu lenken. Hierbei kann es z.B. bei Abgriffen von Transformatoren oder Kabeln zweckmäßig sein, nur den Strom und nicht die Spannung zu messen. Die ermittelten Messwerte werden an eine Regel- und Steuereinheit 103 weitergeleitet, die unter anderem auch die Regeleinheit für die Einstellung des Punktes maximaler Leistung MPP umfasst.

Eine Photovoltaikgenerator 105 ist als regenerativer Energieerzeuger vorgesehen. Die Photovoltaikgenerator 105 erzeugt einen Gleichstrom, der mittels nicht gezeigter elektrischer Zuleitungen zu einer Gleichstromschiene 107 geführt wird. Die Gleichstromschiene 107 liegt in einem Wechselrichter 109, dessen Wechselspannungsseite mit den drei Phasen L, L2, L3 verbunden ist. Die eigentliche Umrichtung des erzeugten Gleichstroms erfolgt für jede Phase getrennt mittels elektronischer Bauelemente, zurzeit bevorzugt mit IGBTs. Dies ist durch drei Wechselrichtersymbole 110a, 110b, 110c innerhalb des Wechselrichters 109 angedeutet.

Von der Regel- und Steuereinheit 103 führen drei getrennte Signalleitungen S10, S20 und S30 zu den drei IGBT-Blöcken, die mit den Wechselrichtersymbolen 110a, 110b und 110c bezeichnet sind. Über diese Signalleitungen S10, S20 und S30 werden die IGBTs derart angesteuert, dass diese die durch die Regel- und Steuereinheit 103 errechneten Einstellungen in Abhängigkeit der Spannungsmesswerte vornehmen. Der Übersichtlichkeit halber sind der Wechselrichter 109 und die Regel- und Steuereinheit 103 getrennt voneinander gezeichnet. In der Realität ist die Regel- und Steuereinheit 103 mit dem MPP-Glied in den Wechselrichter 109 integriert. Es liegt also ein Wechselrichter 109 vor, dessen Regel- und Steuereinheit 103 zusätzlich das beschriebene phasenselektive Blindleistungsmanagement übernimmt.

Hinsichtlich des Betriebs des Wechselrichter109 seien die drei Phasenspannungen L1, L2 und L3 mit den Werten 230V, 235V und 227V gegeben. Dies kann in dem aktuell vorliegenden Verhalten von Verbrauchern oder auch durch eine Vielzahl von unabhängig voneinander in das Netz einspeisende photovoltaische Dachanlagen begründet sein. Dieser Sachverhalt wird von der Messstelle 102 ermittelt und an die Regel- und Steuereinrichtung 103 übermittelt. Diese ist derart programmiert, dass z.B. eine maximale Spannungsdifferenz zwischen den Phasen L1, L2 und L3 von 4V akzeptiert wird, wobei die Phasenspannung in einer vorgebbaren Bandbreite, hier 228V bis 232V, liegen sollte. Das Kriterium 4V kann beliebig nach den Bedürfnissen des Energieversorgers und Netzbetreibers festgelegt werden. Es können auch andere Kriterien, wie die absolute Spannung der drei Phasen L1, L2 und L3 herangezogen werden, ohne den Differenzwert der Spannung zwischen den Phasen Rücksicht zu berücksichtigen.

Die Anforderungen an das Netz können sich auch verändern, weswegen eine alternativ vorgesehen ist, die Regel- und Steuereinheit 103 mit einem Einstelleingang E zu versehen. Über den Einstelleingang E wird dem Wechselrichter 109 von einer Leitwarte aus (nicht gezeigt) das aktuell erforderliche Kriterium übermittelt, was z.B. die aktuell erforderlichen Sollwerte für die drei Phasenspannungen L1, L2 und L3 sein können.

Gemäß dem zuvor genannten Zahlenbeispiel legt die Regel- und Steuereinheit 103 aufgrund der gemessenen Spannungswerte fest, dass die Phase L1 unverändert bleiben soll, dass die Phase L2 durch einen Blindleistungsbezug in ihrer Spannung um wenigstens 3V zu reduzieren ist, und dass die Phase L3 durch eine Blindleistungslieferung um ein Volt (1 V) zu stärken ist. Nach erfolgter Einstellung der beteiligten IGBTs ergibt sich dann ein Spannungsbild für die drei Phasen von L1 = 230V, L2 = 232V und L3 = 228V. Bei gravierenden Abweichungen kann der Wechselrichter 109 zusätzlich zur unsymmetrischen Verteilung der vom PV-Generator 105 erzeugten Leistung auch freie Kapazitäten nutzen, um zur Spannungsanhebung Blindleistung in die Phase L3 einzuspeisen und zur Spannungssenkung Blindleistung aus der Phase L2 zu beziehen.

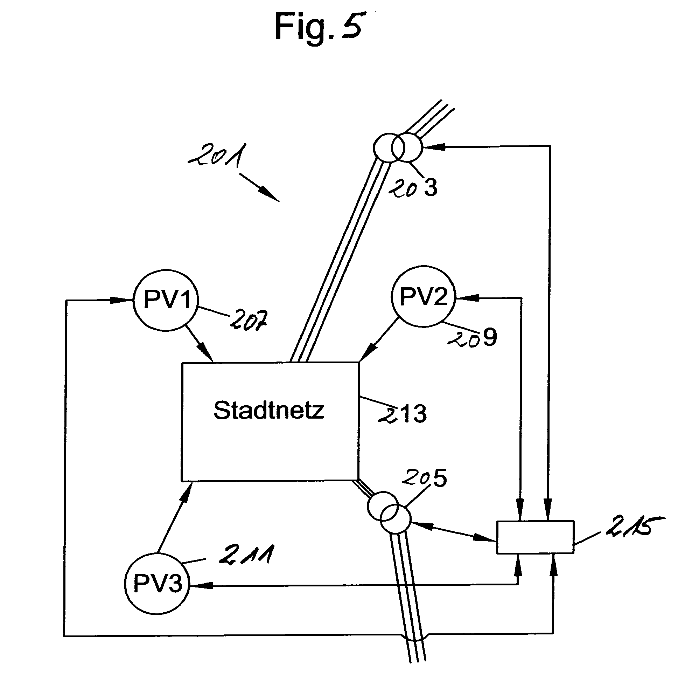

In Fig. 5 ist ein Teil eines öffentlichen Versorgungsnetzes 201 gezeigt, welches einen ersten und einen zweiten Transformator 203 bzw. 205, drei Photovoltaikanlagen 207, 209, 211, ein Stadtnetz 213 und eine Leitwarte 215 beinhaltet. Die Photovoltaikanlagen 207, 209, 211 sind der Übersichtlichkeit halber außerhalb des Stadtnetzes 213 gezeigt, werden aber von dem Versorgungsunternehmen der Stadt betrieben. Die Transformatoren 203, 205 sind auf deren Primärseite mit einem 20kV-Kabel verbunden, und deren Sekundärseite versorgt das Stadtnetz 213 auf der 400V-Ebene. Die primärseitigen Kabel der Transformatoren 203, 205 wiederum führen zu weiteren, nicht gezeigten Transformatoren, die die Transformatoren 203, 205 aus einer 110kV-Ebene heraus mit Spannung versorgen.

Zusätzlich zu den Transformatoren 203, 205 speisen auch die erste, die zweite und die dritte Photovoltaikanlage 207, 209, 211 auf der 20kV-Ebene Leistung in das Stadtnetz 213 ein. Die drei PV-Anlagen 207, 209, 211 bestehen in deren wesentlichen Elementen jeweils aus einem Photovoltaikgenerator, der eine Vielzahl von Photovoltaikmodulen umfasst, deren Photovoltaikzellen einen Gleichstrom erzeugen, und aus einem Wechselrichter, der den erzeugten Gleichstrom in einen Wechselstrom umsetzt.

Der Wechselrichter hat eine an die Nennleistung des PV-Generators angepasste Leistung. Die Anpassung ist derart, dass von der maximal erzeugbaren Leistung ein Abschlag erfolgt, der berücksichtigt, dass für die wenige Zeit im Jahr, an der die Sonne mit der höchstmöglichen Intensität auf die PV-Module einstrahlt, es unwirtschaftlich erscheint, den Wechselrichter auf diese Höchstleistung auszulegen. Desweiteren wird in der Dimensionierung des Wechselrichters ein Blindleistungsanteil berücksichtigt, den der Energieerzeuger in die Versorgungsebene zur Spannungsstabilisierung einbringen muss. Eine solche Verpflichtung ergibt sich aus den Verträgen des örtlichen Betreibers des Stadtnetzes mit den Betreibern der übergeordneten Versorgungsebene.

Bei einem Zahlenbeispiel wird für die erste Photovoltaikanlage 207 von einer maximal erzeugbaren Leistung von 1,55MW ausgegangen, die als Wirkleistung beim höchst möglichen Sonnenstand im Sommer und bei klarem Himmel erreichbar ist. Da diese Konstellation nur wenige Stunden im Jahr auftritt, wird für die Auslegung des Wechselrichters ein Abzug vorgenommen, und es wird von einer Maximalleistung von 1,5MW ausgegangen. Dem Stadtnetzbetreiber mit seinen drei PV-Anlagen 207, 209, 211 sei vom übergeordneten Energieversorger auferlegt, einen cos phi Wert von 0,95 an den Transformatoren 203, 205 und an den PV-Anlagen 207, 209, 211 nicht zu überschreiten.

Die Einspeisung der Leistung der PV-Anlagen 207, 209, 211 wirkt tendenziell spannungserhöhend, so dass von den 1,5MW eine Vorratshaltung für den Blindleistungsbezug von 5% gemacht wird, was bei einer Leistungsauslegung des Wechselrichters 5 auf 1,5MW zu einer maximal möglichen Leistungseinspeisung von 1,5 x 0,95 = 1,425MW führt. Die beiden anderen Photovoltaikanlagen 209, 211 sollen beim Zahlenbeispiel auf jeweils 1 Megawatt (1 MW) Nennleistung ausgelegt sein, von denen 5 % für den Blindleistungsbezug vorzuhalten sind, so dass sie 0,95MW Leistung erbringen können.

Bei bewölktem Himmel herrscht weder eine geschlossene Wolkendecke, noch liegt wolkenloser Himmel vor. Bei einer solchen Wetterlage soll davon ausgegangen werden, dass die erste Photovoltaikanlage 207 mit voller Leistung arbeitet, wegen des fünfprozentigen cos phi Abschlags aber dennoch lediglich 1,425MW Wirkleistung einspeist, also 1,5MW - 1,425 MW = 0,075MW unterhalb ihrer Nennleistung. Zur selben Zeit ist die zweite Photovoltaikanlage 209 teilweise abgeschattet und speist lediglich 0,7MW in das Stadtnetz 213 ein, wobei in den 0,7MW der Blindleistungsanteil bereits berücksichtigt sein soll.

Erfindungsgemäß melden nun beide PV-Anlagen 207, 209 ihre Blindleistungsreserven an die Leitwarte 215. Die erste Photovoltaikanlage 207 meldet also null verfügbare Blindleistungskapazität und die zweite Photovoltaikanlage 209 meldet 0,3MW (1 MW Nennleistung - 0,7 MW momentane Leistung) verfügbare Blindleistungskapazität. Die Leitwarte 215 sendet daraufhin ein Steuersignal an die zweite Photovoltaikanlage 209, welches den Betrieb deren Wechselrichters derart ändert, dass dieser zusätzlich zu den 0,7MW Leistung, die die zweite Photovoltaikanlage 209 generiert, noch weitere 0,075MW Blindleistung bezieht.

Der Wechselrichter der zweiten Photovoltaikanlage 209 wird dann insgesamt mit 0,775MW betrieben, was unterhalb seiner Nennleistung von 1 MW liegt. Der von der Leitwarte 215 zusätzlich angeforderte Blindleistungsbezug von 0,075MW entspricht dem von der ersten Photovoltaikanlage 207 vertragsbedingt abverlangten Blindleistungsbezug, der also nicht mehr von dieser erbracht werden muss, sondern von der zweiten Photovoltaikanlage 209 übernommen wird.

Anschließend oder gleichzeitig sendet die Leitwarte 215 an die erste Photovoltaikanlage 207 ein Steuersignal, dass deren Wechselrichter keinen Blindleistungsbezug mehr vornehmen muss, worauf hin dort ohne Rücksicht auf einen Blindleistungsvorbehalt die Einspeisung der sonnengenerierten Wirkleistung bis hin zur Nennleistung von 1,5MW vorgenommen werden kann. Der Austausch der Daten zwischen den PV-Anlagen und der Leitwarte kann drahtlos oder drahtgebunden erfolgen. Ebenso ist es frei wählbar, welches Bauelement der Photovoltaikanlage 207, 209, 211 die Meldung an die Leitwarte abgibt.

In der vorgenommenen Aufteilung der PV-Anlagen 207, 209, 211 in einen PV-Generator und einen Wechselrichter ist es der Wechselrichter im weitesten Sinne, der die Meldung der verfügbaren Kapazität übernimmt. So kann der Wechselrichter eine Kommunikationsschnittstelle umfassen, die den Betriebszustand der Ansteuerung der IGBTs im Wechselrichter meldet, die eine Meldung im Klartext absetzt, usw.

Bei der obigen beispielhaft geschilderten Situation ist ein Eingriff in den Betrieb des Wechselrichters der dritten Photovoltaikanlage 211 nicht nötig. Es werden vielmehr die freien Blindleistungskapazitäten mehrerer, vorzugsweise aller, auf der betrachteten Versorgungsebene zusammenarbeitenden alternativen Energieerzeuger an die Leitwarte 215 gemeldet, die dann ggf. auch unter Berücksichtigung der geographischen Lage der Energieerzeuger im elektrischen Netz den Blindleistungsbezug und/oder die Blindleistungslieferung des- oder derjenigen Energieerzeuger derart modifiziert, dass eine maximale Leistungsausbeute in der Gesamtschau aller beteiligten Energieerzeuger vorliegt.

Die Erfindung ist nicht auf die vorstehend beschriebene Ausführungsbeispiele beschränkt. Vielmehr können auch andere Varianten der Erfindung von dem Fachmann hieraus abgeleitet werden, ohne den Gegenstand der Erfindung zu verlassen. Insbesondere sind ferner alle im Zusammenhang mit den Ausführungsbeispielen beschriebene Einzelmerkmale auch auf andere Weise miteinander kombinierbar, ohne den Gegenstand der Erfindung zu verlassen

### Bezugszeichenliste

- 1: Photovoltaikanlage
- 3: Photovoltaikgenerator
- 4: Versorgungsnetz
- 5: Wechselrichter
- 7: Strang
- 9: Photovoltaikmodul
- 10: Gleichspannungseingang
- 11: Pluspol
- 13: Minuspol
- 15: Erdfehler
- 17: erstes Schaltelement
- 18: Erde/Masse
- 19: zweites Schaltelement
- 21: Steuervorrichtung
- 23: erste Messvorrichtung
- 25: zweite Messvorrichtung

- 101: Messstelle
- 103: Regel- und Steuereinheit
- 105: PV-Generator
- 107: Gleichstromschiene
- 109: Wechselrichter
- 110a-110c: Wechselrichtersymbol

- 201: Versorgungsnetz
- 203, 205: Transformator
- 207: erste Photovoltaikanlage
- 209: zweite Photovoltaikanlage
- 211: dritte Photovoltaikanlage
- 213: Stadtnetz
- 215: Leitwarte/Systemsteuerung

- E: Einstelleingang
- E1,2: Eingangssignal
- G1,2: Grenzwert
- L1,L2,L3: Phase
- S: Steuer-/Schaltsignal
- S1,2: Steuer-/Schaltsignal
- S2: Steuer-/Schaltsignal
- S10,S20,S30: Signaleingang

## Patentansprüche

1. Wechselrichter (9), insbesondere einer Photovoltaikanlage, der an ein Drei-Phasen-Drehstromversorgungsnetz zur Einspeisung regenerativ erzeugter Energie anschließbar ist,
**gekennzeichnet durch**
Mittel (103, E), insbesondere eine Regel- und/oder Steuereinheit oder einen Steuereingang, zur Veränderung des Betriebsmodus bei Anliegen eines Steuersignals derart, dass seitens des Wechselrichters eine bezüglich der drei Phasen (L1, L2, L3) unsymmetrische Einspeisung von Blindleistung in das oder ein unsymmetrischer Bezug von Blindleistung aus dem Versorgungsnetz (201) erfolgt, oder dass der Wechselrichter (9) auf einer Phase (L1, L2, L3) Leistung aus dem Versorgungsnetz (201) bezieht, während der Wechselrichter (9) auf einer anderen Phase (L1, L2, L3) Leistung in das Versorgungsnetz (201) einspeist.

2. Wechselrichter (9) nach Anspruch 1,
**gekennzeichnet durch**
einen auf einen Punkt maximal erzeugbarer Leistung hinarbeitenden Betriebsmodus, wobei die Leistung unsymmetrisch auf die drei Phasen (L1, L2, L3) verteilt ist.

3. Wechselrichter (9) nach Anspruch 1,
**gekennzeichnet durch**
einen auf einen Punkt maximal erzeugbarer Blindleistung oder auf einen Punkt beziehbarer Blindleistung hinarbeitenden Betriebsmodus, wobei die Blindleistung unsymmetrisch auf die drei Phasen (L1, L2, L3) verteilt ist.

4. Wechselrichter (9) nach einem der Ansprüche 1 bis 3,
**dadurch gekennzeichnet,**
**dass** bei Betrieb die Spannung aller drei Phasen (L1, L2, L3) an einem beliebigen Netzverknüpfungspunkt im Versorgungsnetz (201) gemessen ist, insbesondere an demjenigen Netzverknüpfungspunkt, der den Wechselrichter (9) mit dem Versorgungsnetz (291) verbindet, wobei das Steuersignal unter Zuhilfenahme der drei Spannungsmesswerte gebildet ist.

5. Wechselrichter (9) nach einem der Ansprüche 1 bis 4,
**dadurch gekennzeichnet,**
**dass**, um einen höheren Bezug oder eine höhere Lieferung an Blindleistung an eine ausgewählte Phase (L1, L2, L3) zu beziehen oder liefern zu können, die abgegebene Leistung (P) an der betreffenden Phase (L1, L2, L3) erhöht ist.

6. Verfahren zur Steuerung der Einspeiseleistung eines elektrischen Energieversorgungsnetzes (213) mit mehreren, jeweils einen Wechselrichter aufweisenden Energieerzeugern (207, 209, 211) für regenerative Energie,
**dadurch gekennzeichnet,**
**dass** jeder Wechselrichter dessen aktuell frei verfügbare Blindleistungskapazität und/oder in das Versorgungsnetz eingespeiste Leistung an eine Systemsteuerung (215) meldet, die anhand der Daten zur verfügbaren Blindleistungskapazität bzw. zur Leistung für jeden Energieerzeuger (207, 209, 211) einen Beitrag ermittelt, den der jeweilige Energieerzeuger (207, 209, 211) über dessen Wechselrichter als Blindleistung in das Versorgungsnetz einspeist oder aus diesem bezieht.

7. Verfahren nach Anspruch 6,
**dadurch gekennzeichnet,**
- **dass** jeder Wechselrichter die momentan eingespeiste Leistung als Prozentwert seiner Nennleistung meldet, oder
- **dass** jeder Wechselrichter die momentan eingespeiste oder bezogene Blindleistung als Prozentwert seiner Nennleistung meldet.

8. Verfahren nach Anspruch 6 oder 7,
**dadurch gekennzeichnet,**
- **dass** in der Systemsteuerung (215) die Nennleistung der Wechselrichter der beteiligten Energieerzeuger (207, 209, 211) hinterlegt wird, oder
- **dass** zusätzlich zu den Daten der Kapazität die freie Reserve bis zum Erreichen der Nennleistung des Wechselrichters an die Systemsteuerung (215) gemeldet wird.

9. Verfahren nach einem der Ansprüche 6 bis 8,
**dadurch gekennzeichnet,**
- **dass** die Wechselrichter der mehreren Energieerzeuger (207, 209, 211) Netzbereichen und Spannungsebenen zugeordnet werden, und/oder
- **dass** die geographische Lage der Energieerzeuger (207, 209, 211) in die Ermittlung mit einbezogen wird.

10. Verfahren nach einem der Ansprüche 6 bis 9,
**dadurch gekennzeichnet,**
**dass** sowohl die frei verfügbare Kapazität zur Lieferung oder zum Bezug von Blindleistung und die geographische Lage der Energieerzeuger (207, 209, 211) als auch die Zuordnung der Energieerzeuger (207, 209, 211) zu einem Netzbereich in die Ermittlung einbezogen werden, um durch eine definierte Einspeisung/Bezug von Blindleistung die höchste Wirksamkeit bei der Spannungsstabilisierung zu erreichen.
